# EUROPEAN PATENT APPLICATION

(11) **EP 1 511 080 A2**
(43) Date of publication of application: **02.03.2005**
(21) Application number: 04300560.2
(22) Date of filing: 27.08.2004
(51) Int. Cl.: H01L 23/467, H01L 23/40

(54) **Direct Plugging CPU Cooling Fan**

(30) Priority: 29.08.2003 US 650780
(71) Applicant: Hewlett-Packard Development Company, L.P., Houston, TX 77070 (US)
(72) Inventor: Cohen, Xavier, Hewlett-Packard Company, Houston, TX Texas TX 77070 (US); Greco, Xavier, 38450, Vif (FR)
(74) Representative: Lloyd, Richard Graham

(57) **Abstract**

A CPU heat sink 20 and cooling fan 10 combination is provided which automatically establishes an electrical connection for the cooling fan 10 when the combination in inserted into a chip board 60.

## Description

### BACKGROUND

Traditionally, the cooling fan, of a heat sink associated with a computer's central processing unit ("CPU"), must be pluggedl-in when the heat sink is installed. Unfortunately, often when heat sinks are replaced, the subsequent electrical connection for the cooling fan is either overlooked or simply forgotten, thereby rending the fan inoperable. As a result of the inoperable fan, the heat emitted by the CPU and collected by the heat sink may be inadequately exhausted, thereby causing the CPU to overheat which, in turn, frequently leads to costly CPU failure.

During production, if electrical connections for the cooling fan are not made and this error is later discovered, production must stop so that the connections can be made for each fan which was improperly installed. The time necessary to inspect and connect each cooling fan connection may be considerable. As a result, the production downtime may be rather costly.

### SUMMARY

One embodiment of the invention addresses a cooling apparatus adapted for connection to a chip board. The cooling apparatus includes: (a) a heat sink having a base, wherein the base comprises at least one mechanical fastener adapted to engage at least one corresponding mechanical fastener on a surface of a chip board containing a CPU; and (b) a cooling fan positioned adjacent the heat sink and comprising an electrical connector adapted to be connected to a corresponding electrical connector formed on the surface of the chip board. When the at least one mechanical fastener of the base is engaged with the at least one corresponding mechanical fastener of the chip board, the electrical connector of the cooling fan is automatically engaged with the corresponding electrical connector of the chip board.

Another embodiment of the invention addresses a chip board apparatus adapted for insertion into a computer. The chip board apparatus includes: (a) a chip board comprising a CPU; and (b) a cooling apparatus comprising: (i) a heat sink having a base, wherein the base comprises at least one mechanical fastener engaged to at least one corresponding mechanical fastener on a surface of the chip board, and wherein the heat sink is adjacent the CPU; and (ii) a cooling fan positioned adjacent the heat sink and comprising an electrical connector connected to a corresponding electrical connector formed on the surface of the chip board. When the at least one mechanical fastener of the base is engaged with the at least one corresponding mechanical fastener of the chip board, the electrical connector of the cooling fan is automatically engaged with the corresponding electrical connector of the chip board.

Another embodiment of the invention addresses a method of inserting a CPU heat sink. This method includes the steps of: (a) inserting a heat sink and associated cooling fan onto a chip board proximate a CPU; and (b) simultaneously connecting an electrical connector of the cooling fan with a corresponding electrical connector on the chip board.

Another embodiment of the invention addresses a heat sink and cooling fan assembly mountable on a chip board having a CPU and a power supply electrical contact on a face portion thereof. This assembly includes: (a) a heat sink base having a predetermined registration position relative to said CPU; and (b) a cooling fan electrical contact having a predetermined registration position relative to said power supply contact. The heat sink base and the cooling fan electrical contact are positioned in a predetermined fixed relationship such that said cooling fan electrical contact is placed in said predetermined registration position with said power supply electrical contact when said cooling fan base is placed in said predetermined registration position with said CPU.

These and other features, aspects, and advantages of the present invention will become more apparent from the following description, appended claims, and accompanying exemplary embodiments shown in the drawings.

### BRIEF DESCRIPTION OF THE DRAWINGS

Figure 1 is a side cross-sectional view of an exemplary heat sink, associated cooling fan, CPU, chip board, and computer chassis; and

Figure 2 is a side cross-sectional view of an alternate, exemplary embodiment of the invention in which the fasteners shown in the embodiment of Figure 1 are replaced by one or more levers.

### DETAILED DESCRIPTION

Reference will now be made in detail to various embodiments of the invention, which are illustrated in the drawings. An effort has been made to use the same reference numbers throughout the drawings to refer to the same or like parts.

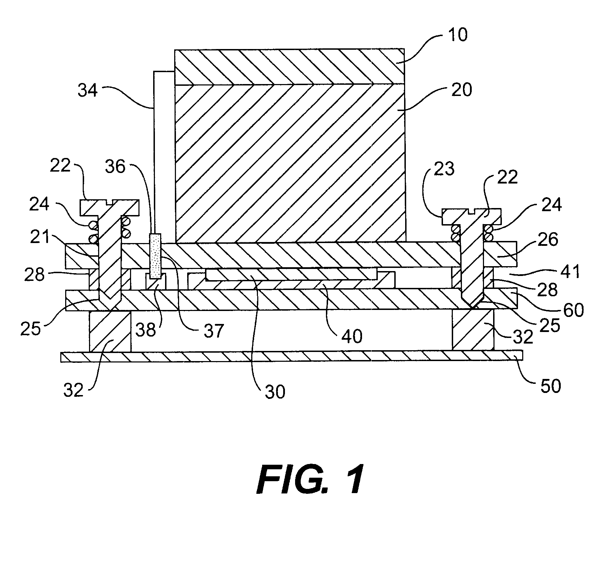

Figure 1 shows a combination heat sink 20 and associated cooling fan 10. The heat sink 20 is connected to a base 26. Although the base 26 and heat sink 20 are shown as being separate (but connected), it should be recognized that the base 26 and the heat sink 20 may be integrally formed. As shown, the base 26 is connected to a chip board 60 by means of one or more fasteners 22 which are journalled through bores 21 in the base 26 and engage corresponding mechanical fasteners 25 formed in the chip board 60.

The fasteners 22 may be screws, as shown. If the fasteners 22 are male threaded screws, the corresponding mechanical fasteners 25 formed in the chip board 60 would be correspondingly threaded female bores.

The screws 22 may be pressure designed to fill the corresponding screw holes 25 such that a tip 27 of the screws 22 is received by a correspondingly tipped hole 25, as shown on the right side of Figure 1. In this orientation, the heads 23 of the screws 22 do not rest against the base 26. Rather, pressure inducers 24 are compressed as the screws 22 are tightened. In one embodiment, the pressure inducers 24 may be springs. It should be readily recognized, however, the other pressure inducers 24 could be employed such as, for example, lock washers.

In the embodiment shown, the compression of the springs 24 pushes the base 26 downward such that the base is forced to lie adjacent a CPU 30. The contact of the CPU and the base enables heat generated by the CPU to be passed by convection through the base 26 and into the heat sink 20.

To create a gap 41 between the base 26 and the CPU chip provided beneath the base 26 (so as to prevent an inadvertent crushing of the CPU when the base 26 is affixed to the chip board 60), spacers 28 may be provided to ensure a minimum separation is preserved. Further, in one embodiment the spacers 28 may be rings which circumscribe the fasteners 22.

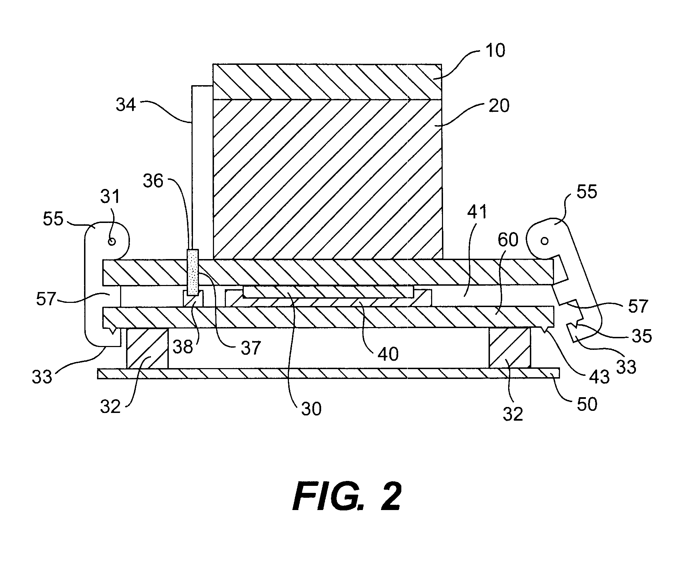

In the embodiment shown in Figure 2, the fasteners 22 take the form of clamps (also referred to as "levers") 55 which rotate on axis 31. In addition, the clamps 55 my have projections 57 formed thereon which serve the same function as the spacers 28 previously described, i.e., they may ensure a gap 41 is maintained between the base 26 and the chip board 60. When the clamps 55 are rotated and the projections 57 separate the chip board 60 and base 26, an end portion 33 of the clamps 55 swings under the chip board 60. To maintain the clamp 55 in this position, a notch 35 may be formed in the end portion 33 which is designed to receive a corresponding lip 43 projecting from an underside of the chip board 60; the engagement between the lip 43 and the notch 35 may be a friction-fit engagement.

As shown in Figures 1 and 2, the chip board 60 may be connected to the chassis 50 of a computer or other chip board. Moreover, the chip board 50 may be connected to the chassis 50 by means of one or more stand-offs 32. Further, the stand-offs 32 may be integrally formed with the chip board 60 and/or the chassis 50.

An electrical connector 36, which is electrically connected to the cooling fan 10 by means of a conductor 34 (e.g., a wire), is journalled though another bore 37 in the base 26. At least a portion of the electrical connector 36 may be fixedly attached to the base 26 within the bore 37 such that the electrical connector 36 is relatively fixed with respect to the base 26.

When the base is connected to the chip board 60, the base 26 is forced to be adjacent the CPU 30 (which is located in a socket 40 formed in the chip board 60). The base 26 is forced to be adjacent the CPU 30 because of the alignment of the fasteners 22 and their corresponding mechanical fasteners 25, followed by the subsequent tightening of the fasteners 22. In addition, as the fasteners 22 are tightened, the electrical connector 36 of the cooling fan 10 is automatically aligned with, and engages, a corresponding electrical connector 38 formed in the chip board 60.

The aforementioned assembly greatly improves over the prior art. Not only does the assembly provide for automatic connection of the electrical connection for the cooling 10, it provides for a plurality of other related benefits. Significantly, the assembly can prevent the production downtime which previously occurred when it was discovered that electrical connections for the cooling fans were not being systematically made. Second, as a result of the fixed connection, there is a greatly reduced risk that the electrical connection will subsequently be undone, even during periods when the CPU is being transported. Finally, the EMI performance of the CPU design is enhanced due to the shortness of the length of the conductor 34 which, in turn, reduces electromagnetic emissions. Moreover, the generally straight orientation of the conductor 34 prevents the creation of induction which might otherwise occur if the conductor were in the form of a coil.

Although the aforementioned describes embodiments of the invention, the invention is not so restricted. It will be apparent to those skilled in the art that various modifications and variations can be made to the disclosed embodiments of the present invention without departing from the scope or spirit of the invention. For example, the fasteners 22 could pass through the chip board 60 and engage bores formed in the chassis 32. Moreover, such a design could employ spacers (similar to that of the spacers 28 between the chip board 60 and the base 26) to serve the roll of the stand-offs 32.

Accordingly, these other cooling apparatus embodiments are fully within the scope of the claimed invention. Therefore, it should be understood that the apparatus and method described herein are illustrative only and are not limiting upon the scope of the invention, which is indicated by the following claims.

## Claims

1. A cooling apparatus adapted for connection to a chip board, the apparatus comprising:
a heat sink 20 having a base 26, wherein the base 26 comprises at least one mechanical fastener 22, 55 adapted to engage at least one corresponding mechanical fastener 25, 43 on a surface of a chip board 60 containing a CPU 30;
a cooling fan 10 positioned adjacent the heat sink 20 and comprising an electrical connector 36 adapted to be connected to a corresponding electrical connector 38 formed on the surface of the chip board 60;
wherein when the at least one mechanical fastener 22, 55 of the base 26 is engaged with the at least one corresponding mechanical fastener 25, 43 of the chip board 60, the electrical connector 36 of the cooling fan 10 is engaged with the corresponding electrical connector 38 of the chip board 60.

2. The cooling apparatus according to claim 1, wherein the electrical connector 36 of the cooling fan 10 is journalled through a hole 37 in the base 26.

3. The cooling apparatus according to claim 1, wherein when the at least one mechanical fastener 22, 55 of the base 26 is engaged with the at least one corresponding mechanical fastener 25, 43 of the chip board 60, the base 26 will be detachably positioned above the CPU 30.

4. The cooling apparatus according to claim 1, wherein the at least one mechanical fastener 22 of the base 26 comprises a pressure inducer 24 which is compressed when the at least one mechanical fastener 22 of the base 26 is engaged with the at least one corresponding mechanical fastener 25 of the chip board 60.

5. The cooling apparatus according to claim 1, wherein the at least one fastener 22, 55 of the base 26 is selected from the group consisting of a screw or a clamp.

6. The cooling apparatus according to claim 1, wherein the chip board 60 comprises two corresponding mechanical fasteners 25, 43, and wherein the base 26 comprises two mechanical fasteners 22, 55 which are adapted to engage the two corresponding mechanical fasteners 25, 43 of the chip board 60.

7. A method of inserting a CPU heat sink, the method comprising the steps of:
inserting a heat sink and associated cooling fan onto a chip board proximate a CPU; and
simultaneously connecting an electrical connector of the cooling fan with a corresponding electrical connector on the chip board.

8. The method according to claim 7, wherein before the step of inserting the heat sink and associated cooling fan, the method further comprises the steps of:
detaching a preexisting heat sink and associated preexisting cooling fan from the chip board; and
removing the preexisting heat sink and the associated preexisting cooling fan.

9. The method according to claim 7, wherein the step of inserting a heat sink and associated cooling fan comprises:
aligning at least one fastener of a base to which the heat sink is connected with corresponding mechanical fasteners formed in the chip board; and
tightening the at least one fastener to bring the base adjacent the CPU.

10. A heat sink and cooling fan assembly mountable on a chip board having a CPU and a power supply electrical contact on a face portion thereof comprising:
a heat sink base 26 having a predetermined registration position relative to said CPU 30; and
a cooling fan electrical contact 36 having a predetermined registration position relative to said power supply contact 38;
wherein said heat sink base 26 and said cooling fan electrical contact 36 are positioned in a predetermined fixed relationship such that said cooling fan electrical contact 36 is placed in said predetermined registration position with said power supply electrical contact 38 when said cooling fan base 26 is placed in said predetermined registration position with said CPU 30.
